(19) Europäisches Patentamt
European Patent Office
Office européen des brevets

(11) Veröffentlichungsnummer: **0 243 833**
**A2**

(12) **EUROPÄISCHE PATENTANMELDUNG**

(21) Anmeldenummer: **87105760.0**

(51) Int. Cl.⁴: **C08G 65/40**, H01B 3/30

(22) Anmeldetag: **18.04.87**

(30) Priorität: **30.04.86 DE 3614753**

(43) Veröffentlichungstag der Anmeldung:
**04.11.87 Patentblatt 87/45**

(84) Benannte Vertragsstaaten:
**BE DE FR GB NL**

(71) Anmelder: **BASF Aktiengesellschaft**
**Carl-Bosch-Strasse 38**
**D-6700 Ludwigshafen(DE)**

(72) Erfinder: **Heinz, Gerhard, Dr.**
**Im Vogelsang 2**
**D-6719 Weisenheim(DE)**

(54) **Hochtemperaturbeständige Copolykondensat-Formmassen.**

(57) Copolykondensat-Formmassen, erhältlich durch Polykondensation von
2 bis 98 mol.% 2,2-Di(4'-hydroxyphenyl)propan (A)
2 bis 98 mol.% 4,4'-Dihydroxydiphenylsulfon (B)
0 bis 96 mol.% (C)

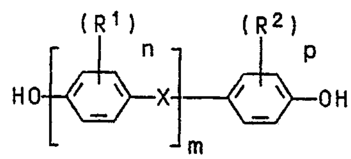

($R^1$, $R^2$ = H, $C_1$-$C_6$-Alkyl oder $C_1$-$C_6$-Alkoxy, X = chem. Bindung, -S-, -O-, -CO-, $CR^3R^4$ ($R^3$ = $R^4$ wenn n und p = 0), -$SO_2$-(nur wenn n oder p = 0; $R^3$, $R^4$ = H, $C_1$-$C_6$-Alkyl, $C_1$-$C_6$-Alkoxy, Aryl, halogensubst. Alkyl mit 1 bis 4 C; m = 0 oder 1, n, p = 0, 1, 2, 3 oder 4)
mit
1 bis 100 mol.% (D)

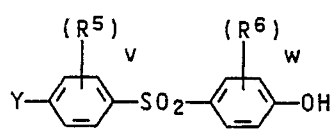

($R^5$, $R^6$ eine gleiche Bedeutung wie $R^1$, $R^2$ haben, v, w = 0, 1, 2, 3 oder 4)
0 bis 99 mol.% (E)

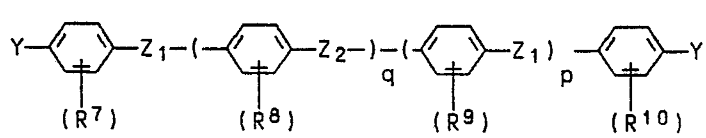

EP 0 243 833 A2

($R^7$-$R^{10}$ = Cl, F oder wie $R^1$ und $R^2$, q = 0 oder 1, r, s, t, n = 0, 1, 2, 3 oder 4; $Z_1$ = -$SO_2$-oder -CO-; $Z_2$ = -O-, -S-, -$SO_2$-, -CO-oder chem. Bindung),
mit der Maßgabe, daß mindestens eine der Komponenten C oder E vorhanden ist und das molare Verhältnis von B zur Summe von A+C nicht größer als 1 ist.

## Hochtemperaturbeständige Copolykondensat-Formmassen

Die Erfindung betrifft hochtemperaturbeständige Copolykondensat-Formmassen mit Polyarylensulfon- und Polyarylenethersulfoneinheiten in statistischer Verteilung, erhältlich durch Polykondensation einer Mischung von

A) 2 bis 98 mol.%, bezogen auf die Summe von A)-C),

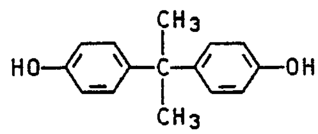

B) 2 bis 98 mol.%, bezogen auf die Summe von A)-C),

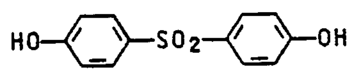

C) 0 bis 96 mol.%, bezogen auf die Summe von A)-C),

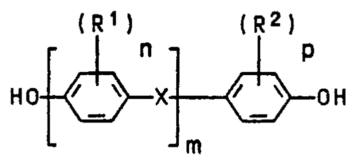

wobei X eine chemische Bindung oder einen Substituenten

-S-, -O-, $-\overset{O}{\overset{\|}{C}}-$,

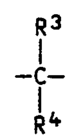

($R^3 \neq R^4$ wenn gleichzeitig n und p = 0),

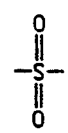

(nur wenn n oder p = 0)

$R^1$ und $R^2$ Alkylgruppen mit 1 bis 6 C-Atomen oder $C_1$-$C_6$-Alkoxygruppen, $R^3$ und $R^4$ Wasserstoffatom, Alkylgruppen mit 1 bis 6 C-Atomen, Arylgruppen oder halogensubstituierte Alkylgruppen mit 1 bis 4 C-Atomen darstellen und m den Wert 0 oder 1 und n und p den Wert 0, 1, 2, 3 oder 4 haben,
mit

D) 1 bis 100 mol.%, bezogen auf die Summe von D) und E)

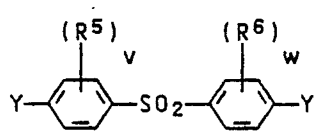

wobei $R^5$ und $R^6$ Wasserstoff sind oder die gleiche Bedeutung wie $R^1$ und $R^2$ haben und v und w jeweils den Wert 0, 1, 2, 3 oder 4 haben, und

E) 0 bis 99 mol.%, bezogen auf die Summe von D) und E)

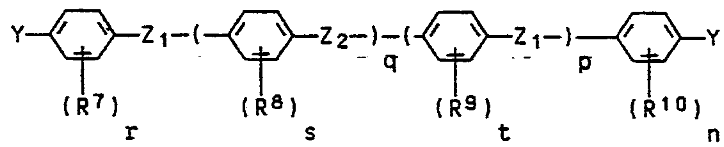

wobei

Y : C1 oder F

$Z_1$ : 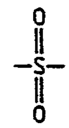

oder 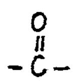

$Z_2$: -O-, -S-,

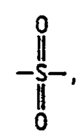

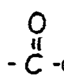 -oder eine chemische Bindung darstellen,

$R^7$, $R^8$, $R^9$ und $R^{10}$, Wasserstoff, Cl oder F sind oder die gleiche Bedeutung wie $R^1$ und $R^2$ haben können,
q und p den Wert 0 oder 1 haben und
r, s, t und u eine ganze Zahl von 0 bis 4 sein können,
mit der Maßgabe, daß mindestens eine der Komponenten C oder E enthalten ist und das molare Verhältnis von B zur Summe von A + C nicht größer als 1 ist.

Außerdem betrifft die Erfindung ein Verfahren zur Herstellung solcher Copolykondensat-Formmassen und deren Verwendung zur Herstellung von Leiterplatten und elektrischen Steckverbindungen sowie Formkörper, die aus den erfindungsgemäßen Copolykondensat-Formmassen als wesentliche Komponenten erhältlich sind.

Polyethersulfone mit der allgemeinen Struktureinheit

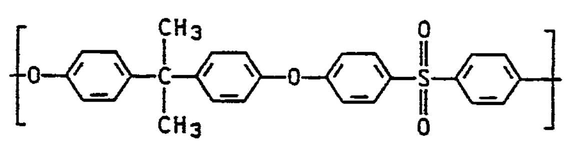

(häufig, wie auch im folgenden, einfach als Polysulfone bezeichnet) zeichnen sich durch eine sehr geringe Wasseraufnahme und damit eine sehr gute Formstabilität (der daraus hergestellten Formteile) aus. Die Wärmeformbeständigkeit, (die häufig durch die maximale Dauergebrauchstemperatur beschrieben wird) ist jedoch für einige Anwendungszwecke, insbesondere im Falle von aus diesen Massen hergestellten Leiterplatten (printed circuit boards, auch PCB genannt) nicht ausreichend.

Polyethersulfone mit der allgemeinen Struktureinheit

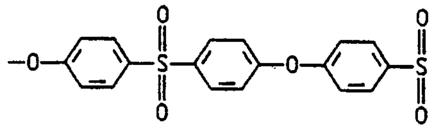

weisen im Vergleich zu Polysulfonen eine bessere Wärmeformbeständigkeit auf, doch ist die Wasseraufnahme wesentlich höher. Dies hat zur Folge, daß Formteile aus Polyethersulfonen zur Quellung und zum Verzug neigen, was bei der Verwendung in der Elektrotechnik und Elektronik (Herstellung von Leiterplatten für gedruckte Schaltungen) unerwünscht ist.

Mischungen aus Polysulfonen und Polyethersulfonen zeigen einen linearen Zusammenhang zwischen Mischungsverhältnis und Wasseraufnahme, jedoch wird die Wärmeformbeständigkeit durch den Polysulfon-Anteil negativ beeinflußt. Zudem sind Formteile aus derartigen Mischungen infolge der Unverträglichkeit der beiden Komponenten nicht mehr transparent, was einen wesentlichen Nachteil darstellt.

In der US-A 4 175 175 und der EP-A 113 112 sowie der EP-A 135 130 werden Copolykondensate beschrieben, die durch Kondensation von Mischungen aus 2,2-Di-(4-hydroxyphenyl)propan (Bisphenol A) und 4,4'-Dihydroxydiphenylsulfon (Bisphenol S) mit 4,4'-Dichlordiphenylsulfon (DCDPS) erhältlich sind.

In der EP-A 113 112 werden auch Copolykondensate aus einer Mischung von Dihydroxyverbindungen A, B und C und Dihalogenverbindungen des Typs D beschrieben. Das Verhältnis der molaren Anteile von B zu A und C ist jedoch stets größer als 1, was sich nachteilig auf die Wasseraufnahme auswirkt.

Diese Copolykondensate weisen zwar gegenüber den Polysulfonen bzw. Polyethersulfonen insgesamt verbesserte Eigenschaften auf, doch sind die Wärmeformbeständigkeit und die Spannungsrißbeständigkeit noch verbesserungsbedürftig. Zur Herstellung von Leiterplatten für gedruckte Schaltungen eignen sich diese Copolykondensate nur sehr bedingt.

Der Erfindung lag daher die Aufgabe zugrunde, hochtemperaturbeständige Copolykondensate mit einem ausgewogenen Eigenschaftsspektrum, d.h. einer ausreichenden Wärmeformbeständigkeit bei geringer Wasseraufnahme und hoher Spannungsrißbeständigkeit zur Verfügung zu stellen, die zur Herstellung von Leiterplatten, insbesondere Leiterplatten für gedruckte Schaltungen (printed circuit boards), geeignet sind.

Diese Aufgabe wird erfindungsgemäß durch die eingangs definierten hochtemperaturbeständige Copolykondensat-Formmassen gelöst.

Bevorzugte Copolykondensate dieser Art sind den Unteransprüchen und der nachfolgenden detaillierten Beschreibung zu entnehmen.

Die erfindungsgemäßen hochtemperaturbeständigen Copolykondensate sind erhältlich durch Polykondensation einer Mischung von aromatischen Dihydroxyverbindungen A, B und gegebenenfalls C, mit aromatischen Dihalogenverbindungen D und gegebenenfalls E, wobei mindestens eine der Verbindungen C und E zwingend vorhanden sein muß.

Bei der Dihydroxyverbindung A handelt es sich um das als Bisphenol A bekannte 2,2-Di-(4-hydroxyphenyl)propan und bei der Dihydroxyverbindung B um 4,4'-Dihydroxydiphenylsulfon, auch als Bisphenol S bezeichnet.

Die Dihydroxyverbindungen C haben die allgemeine Formel

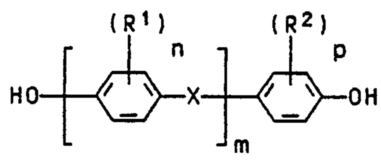

wobei X eine chemische Bindung oder einen Substituenten des Typs

-S-, -O-, 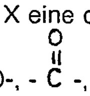 -,

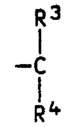

($R^3 \neq R^4$ wenn n und p = 0),

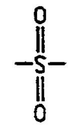

(wenn n oder p = 0)
$R^1$ und $R^2$ Alkylgruppen mit 1 bis 6 C-Atomen oder Alkoxygruppen mit 1 bis 6 C-Atomen,
$R^3$ und $R^4$ Wasserstoff, Alkylgruppen oder Alkoxygruppen mit 1 bis 6 C-Atomen, Arylgruppen oder halogensubstituierte Alkylgruppen mit 1 bis 4 C-Atomen darstellen,
m den Wert 0 oder 1, vorzugsweise 1, und
n und p den Wert 0, 1, 2, 3 oder 4 haben.

Vorzugsweise sind $R^1$ und $R^2$ eine Alkylgruppe mit 1 bis 4 C-Atomen, z.B. Methyl-, Ethyl-, i-oder n-Propyl oder n-, i-oder t-Butyl oder entsprechende Alkoxygruppen. Besonders bevorzugt sind Methyl und Ethyl.

Bevorzugte Substituenten $R^3$ und $R^4$ sind $C_1$-$C_4$-Alkylgruppen, wie für $R^1$ und $R^2$ beschrieben, sowie Arylgruppen oder halogensubstituierte Alkylgruppen wie $CF_3$ und $CCl_3$, um nur zwei Beispiele zu nennen.

m steht für die Zahl 0 oder 1 und ist bevorzugt 1, insbesondere dann, wenn p gleich 0 ist, d.h. keine Substituenten $R^2$ vorhanden sind.

n und p können jeweils 0, 1, 2, 3 oder 4 sein, vorzugsweise 0, 1, 2 oder 3.

Nachfolgend werden einige Beispiele für bevorzugte Dihydroxyverbindungen aufgeführt:

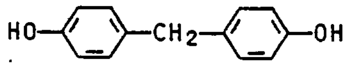
Di-(4-hydroxyphenyl)methan

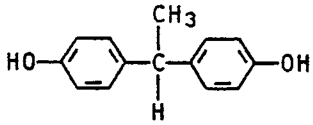
2,2-Di(4-hydroxyphenyl)ethan

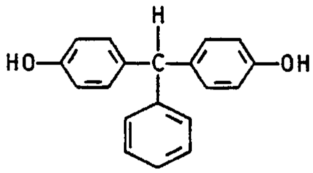
1-Phenyl-1,1-di-(4-hydroxyphenyl)methan

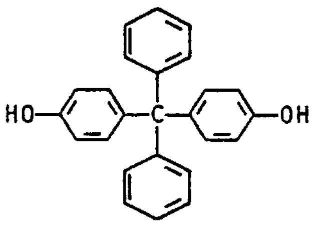
Diphenyl-di-(4-hydroxyphenyl)methan

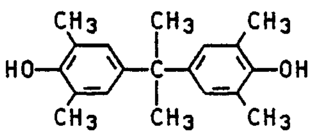
Tetramethylbisphenol A

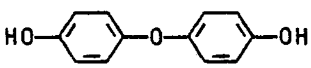
4,4'-Dihydroxydiphenylether

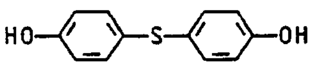
4,4'-Dihydroxydiphenylsulfid

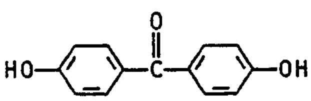
Dihydroxybenzophenon

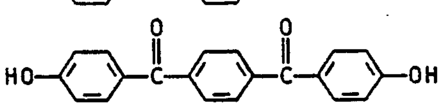
1,4-Di-(4'-hydroxyphenylcarbonyl)benzol

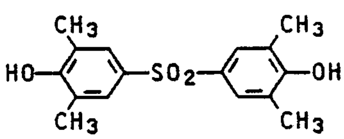
Tetramethylbisphenol S

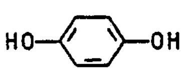
Hydrochinon

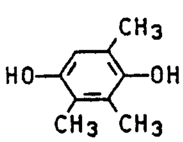
2,3,6-Trimethylhydrochinon

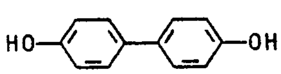
4,4'-Dihydroxydiphenyl

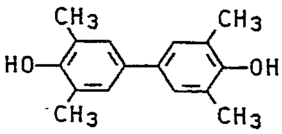

3,3',5,5'-Tetramethyl-4,4'-dihydroxydiphenyl

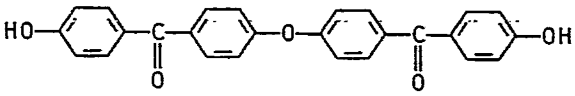

Dihydroxybenzophenonylether

Die Mischung aus den Dihydroxyverbindungen A, B und gegebenenfalls C, enthält
2 bis 98 mol.% A
2 bis 98 mol.% B
0 bis 96 mol.% C, jeweils bezogen auf die Summe von A-C.

Bevorzugt werden Mischungen, die
20 bis 80, insbesondere 25 bis 70 mol.% A
20 bis 80, insbesondere 25 bis 70 mol.% B
0 bis 60, insbesondere 5 bis 60 mol.% C
enthalten.

Die Komponente C ist stets dann in der Mischung enthalten, wenn keine Komponente E eingesetzt wird. In diesem Fall werden in der Regel 5 bis 60, vorzugsweise 10 bis 40 mol.% an Dihydroxyverbindung C, bezogen auf die Summe der Verbindungen A bis C, eingesetzt.

Das molare Verhältnis von Dihydroxyverbindung B zur Summe von A und gegebenenfalls C ist maximal 1. Wird dieses Verhältnis größer als 1, so leidet darunter die Wasseraufnahme, die zu hoch wird. Derartige Produkte sind für die Herstellung von Bauteilen in der Elektrotechnik und Elektronik weniger geeignet.

Bei den Verbindungen D und gegebenenfalls E, durch deren Umsetzung mit der Mischung der Verbindungen A, B und gegebenenfalls C die erfindungsgemäßen hochtemperaturbeständigen Copolykondensat-Formmassen erhältlich sind, handelt es sich um aromatische Dihalogenverbindungen. Verbindung D ist 4,4'-Dichlor-bzw. 4,4'-Difluordiphenylsulfon bzw. deren $C_1$-$C_6$-alkylsubstituierte oder halogensubstituierte Derivate wie 3,3,5,5'-Tetramethyl-4,4'dichlordiphenylsulfon bzw. die entsprechende Fluorverbindung. Die beiden Halogensubstituenten können gleich oder verschieden sein. v und w können 0, 1, 2. 3 oder 4, vorzugsweise 0, 1 oder 2 sein.

Die Verbindungen E haben die allgemeine Formel

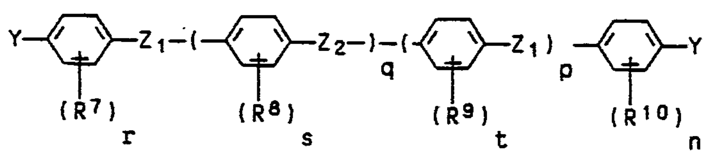

wobei
Y : Cl oder F

$Z_1$: 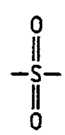

oder 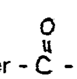

$Z_2$: -O-, -S-,

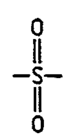,

$-\overset{O}{\overset{\|}{C}}-$ -oder eine chemische Bindung darstellen,

$R^7$, $R^8$, $R^9$ und $R^{10}$ Wasserstoff, Cl oder F sind oder die gleiche Bedeutung wie $R^1$ und $R^2$ haben können, q und p den Wert 0 oder 1 haben und r, s, t und u eine ganze Zahl von 0 bis 4 sein können.

Bevorzugt ist $Z_2$ eine chemische Bindung,

$-\overset{O}{\overset{\|}{C}}-$ -oder $-SO_2-$

und $R^7$, $R^8$, $R^9$ und $R^{10}$ sind bevorzugt Wasserstoff, Methyl, Ethyl oder Cl oder F. r, s, t und u können jeweils 0, 1, 2, 3 oder 4, vorzugsweise 0, 1 oder 2 sein.

Nachfolgend seien nur stellvertretend einige bevorzugte Dihalogenverbindungen D bzw. E aufgeführt.

Name der Chlorverbindung

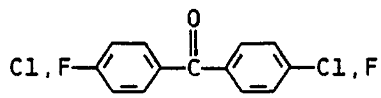
4,4'-Dichlorbenzophenon

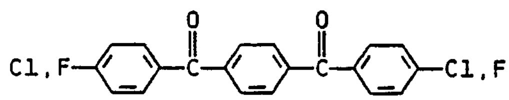
1,4-Di-(4'-chlorphenylcarbonyl)benzol

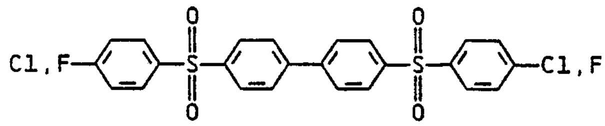
1,10-Di-(4'-chlorphenylsulfon)-diphenyl

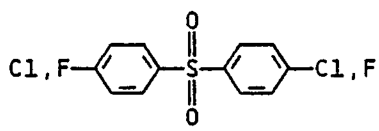
4,4'-Dichlordiphenylsulfon

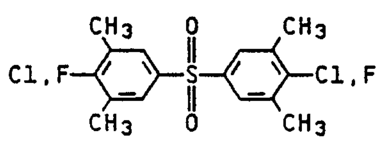
3,3',5,5'-Tetramethyl-4,4'-dichlordi-phenylsulfon

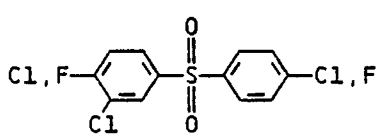
3-Chlor-4,4'-dichlordiphenylsulfon

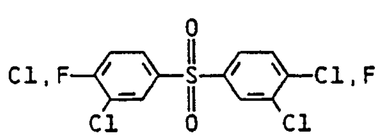
3,3'-4,4'-Tetrachlordiphenylsulfon

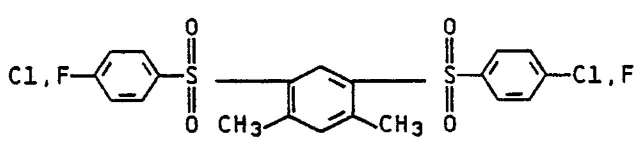
1,3-Dimethyl-4,6-di-(4-chlor-phenylsulfon)benzol

Der Anteil an Dihalogenverbindung D beträgt 1 bis 100 mol.%, bezogen auf die Summe von D und E, vorzugsweise 20 bis 100 mol.%, besonders bevorzugt 50 bis 100 mol.%.

Die Dihalogenverbindungen E sind dann vorhanden, wenn keine Dihydroxiverbindung C eingesetzt wird. In diesem Fall beträgt der Anteil der Dihalogenverbindung E vorzugsweise 5 bis 50, besonders bevorzugt 10 bis 40 mol.%, bezogen auf die Summe von D und E.

Die erfindungsgemäßen Copolykondensat-Formmassen können mit anderen Thermoplasten, beispielsweise Polyestern, Polyamiden, Polyurethanen, Polyolefinen, Polyvinylchlorid und Polyoxymethylenen in Mengen von 5 bis 50 Gew.%, vorzugsweise von 20 bis 50 Gew.%, bezogen auf die Formmassen, gemischt werden.

Sie können außerdem mit verstärkend wirkenden Füllstoffen, gegegebenenfalls transparenten Pigmenten und anderen Hilfs-und Zusatzstoffen modifiziert werden.

Als verstärkend wirkende Füllstoffe seien beispielsweise Asbest, Kohle und vorzugsweise Glasfasern genannt, wobei die Glasfasern z.B. in Form von Glasgeweben, -matten, -vliesen und/oder vorzugsweise Glasseidenrovings oder geschnittener Glasseide aus alkaliarmen E-Glasen mit einem Durchmesser von 5 bis 200 µm, vorzugsweise 8 bis 15 µm, zur Anwendung gelangen, die nach ihrer Einarbeitung eine mittlere Länge von 0,05 bis 1 mm, vorzugsweise 0,1 bis 0,5 mm, aufweisen. Die mit Glasseidenrovings oder geschnittener Glasseide verstärkten Formmassen enthalten zwischen 10 und 60 Gew.%, vorzugsweise 20 bis 50 Gew.%, des Verstärkungsmittels, bezogen auf das Gesamtgewicht, während die imprägnierten Glasgewebe, -matten und/oder -vliese zwischen 10 und 80 Gew.%, vorzugsweise zwischen 30 und 60 Gew.% Copolykondensate, bezogen auf das Gesamtgewicht, enthalten. Als Pigmente eignen sich beispielsweise Titandioxid, Cadmium-, Zinksulfid, Bariumsulfat und Ruß. Als andere Zusatz-und Hilfsstoffe kommen beispielsweise in Betracht Farbstoffe, Schmiermittel, wie z.B. Graphit oder Molybdändisulfid, Schleifmittel, wie z.B. Carborund, Lichtstabilisatoren und Hydrolyseschutzmittel. Die Pigmente, Zusatz-und Hilfsstoffe werden üblicherweise in Mengen von 0,01 bis 3 Gew.%, bezogen auf das Gewicht an Polykondensaten, eingesetzt.

Auch Wollastonit, Calciumcarbonat, Glaskugeln, Quarzmehl, Si-und Bornitrid oder Mischungen dieser Füllstoffe sind verwendbar.

Die Polykondensation der Dihydroxiverbindungen A, B und gegebenenfalls C mit den Dihalogenverbindungen D und gegebenenfalls E kann im Prinzip nach den für die Herstellung von Polysulfonen oder Polyethersulfonen bekannten Verfahren erfolgen, die in der Literatur beschrieben sind. Im folgenden wird stellvertretend ein bevorzugtes Verfahren zur Herstellung der erfindungsgemäßen Copolykondensate beschrieben.

Die Mischung aus den aromatischen Dihydroxyverbindungen A, B und gegebenenfalls C kann in einem molaren Verhältnis von 0,8:1 bis 1,2:1, vorzugsweise 0,9:1 bis 1,1:1, insbesondere 0,98:1 bis 1,02:1 mit aromatischen Dihalogenverbindungen, und besonders bevorzugt mit einer äquimolaren Menge an aromatischen Dihalogenverbindungen in Gegenwart von 1,0 bis 2,0 mol, vorzugsweise 1,05 bis 1,5 mol eines wasserfreien Alkalicarbonats, insbesondere $K_2CO_3$, in einem aprotischen, polaren Lösungsmittel umgesetzt werden.

Als geeignete aprotische polare Lösungsmittel werden N-substituierte Säureamide und Lactame bevorzugt. Nur beispielsweise seien N,N-Dimethylformamid, N,N-Dimethylacetamid oder N-Methylpyrrolidon genannt.

Falls gewünscht kann dem Lösungsmittel ein Azeotropbildner zur Entfernung des Reaktionswassers zugegeben werden. Derartige Verbindungen sind in der Literatur beschrieben. Vorteilhaft läßt sich jedoch auch in Abwesenheit eines Azeotropbildners arbeiten.

Die Menge der Monomeren, bezogen auf die Gesamtmenge des Lösungsmittels beträgt im allgemeinen 20 bis 80, vorzugsweise 30 bis 70, insbesondere 40 bis 60 Gew.%.

Bei Temperaturen im Bereich von 100 bis 200, vorzugsweise 130 bis 180°C kann der Hauptanteil des gebildeten Reaktionswassers entfernt werden. Dies kann z.B. allein thermisch, durch Zugabe eines Azeotropbildners oder bevorzugt durch Anlegen eines Unterdrucks erfolgen.

Anschließend kann die Kondensation bei Temperaturen im Bereich von 180 bis 220°C bis zur Erreichung der gewünschten Molmasse bzw. des gewünschten Kondensationsgrads weitergeführt werden.

Die Reaktionszeit beträgt in der Regel insgesamt von 5 bis 20, vorzugsweise von 7 bis 15 h und ist natürlich von den Reaktionsbedingungen (Temperatur und Druck) sowie von der gewünschten Molmasse des Produkts abhängig.

Im Anschluß an die Polykondensation können zur Stabilisierung freie Phenolat-Endgruppen mit einem Aryl-oder Alkylierungsmittel, wie z.B. Methylchlorid, umgesetzt werden. Dies erfolgt vorzugsweise bei Temperaturen von 50 bis 200, vorzugsweise 50 bis 150°C.

Das bei der Polykondensation anfallende suspendierte Alkalihalogenid kann mit einer geeigneten Trenneinrichtung, beispielsweise einem Klärfilter oder einer Zentrifuge abgetrennt werden.

Die Isolierung der Copolykondensate aus der Lösung kann durch Verdampfen des Lösungsmittels oder Ausfällung in einem geeigneten Nicht-Lösungsmittel erfolgen.

Die erfindungsgemäßen Copolykondensate, insbesondere nach dem vorstehend beschriebenen Verfahren hergestellte Produkte, haben im allgemeinen eine reduzierte Viskosität in 1 Gew.% Phenol/o-Dichlorbenzol (1:1)-Lösung bei 25°C, von 0,35 bis 2,0, vorzugsweise 0,45 bis 1,0, insbesondere 0,45 bis 0,85.

Die erfindungsgemäßen Copolykondensat-Formmassen zeichnen sich durch ihre ausgewogenen Eigenschaften aus. Bei einer hohen Wärmeformbeständigkeit und einer guten Spannungsrißbeständigkeit zeichnen sie sich durch eine geringe Wasseraufnahme aus und sind sehr gut verarbeitbar.

Die erfindungsgemäßen Formmassen können zur Herstellung von Formkörpern, Folien und Fasern verwendet werden. Insbesondere eignen sie sich wegen ihrer guten Eigenschaften zur Herstellung von Leiterplatten und elektrische Steckverbindungen.

Beispiel 1 V (Vergleich)

In einem 300 l Behälter mit Rührer und $N_2$-Anschluß wurden unter Stickstoffatmosphäre 86 kg N-Methylpyrrolidon, 11,41 kg Bisphenol A (50 mol), 12,51 kg 4,4'Dihydroxydiphenylsulfon (50 mol) und 28,72 kg 4,4'-Dichlordiphenylsulfon gelöst und mit 15,2 kg wasserfreiem Kaliumcarbonat (150 mol) versetzt.

Die Reaktionsmischung wurde bei einem Druck von 300 mbar (30 kPa) unter ständigem Abdestillieren des Reaktionswassers und N-Methylpyrrolidon zunächst 1 h auf 180°C erhitzt und 3 h bei dieser Temperatur belassen. Danach wurde 6 h bei 190°C weiter umgesetzt.

Durch Zusatz von Methylchlorid bei einer Temperatur von 150°C und zweistündiger Reaktion unter Druck (0,5 bar) wurde die Polykondensation abgebrochen.

Nach Zugabe von 125 kg N-Methylpyrrolidon wurden die anorganischen Bestandteile abfiltriert und das Polymere durch Fällung in Methanol als Feststoff isoliert. Nach Trocknung bei 100°C im Vakuum wurde das Polymer in Granulat konfektioniert.

Beispiel 2 V (Vergleich)

Es wurde wie in Beispiel 1 gearbeitet, nur unter Verwendung von 25 Mol.% Bisphenol A und 75 Mol.% 4,4'-Dihydroxydiphenylsulfon.

Beispiel 3 V (Vergleich)

Es wurde wie in Beispiel 1 gearbeitet, jedoch eine Mischung aus 75 Mol.% Bisphenol A und 25 Mol.% 4,4'-Dihydroxydiphenylsulfon (DHDPS) eingesetzt.

Beispiel 4 V (Vergleich)

Es wurde eine 50/50 (Mol.%)-Mischung aus Polysulfon und Polyethersulfon eingesetzt.

Beispiele 5 bis 13

Es wurde wie in Beispiel 1 gearbeitet, nur die in der Tabelle angegebenen Dihydroxyverbindungen und Dihalogenverbindungen eingesetzt.

Dabei werden folgende Abkürzungen verwendet:

Bis A Bisphenol A
T-Bis A Tetramethylbisphenol A
DHDPS 4,4'-Dihydeoxydiphenylsulfon
DHDP 4,4'-Dihydroxydiphenyl
T-DHDP 3,3',5,5'-Tetramethyl-4,4'-dihydroxydiphenyl
TMH 2,3-Trimethylhydrochinon
DCDPS 4,4'-Dichlordiphenylsulfon
DDP 1,10-Di(4'-chlorphenylsulfon)diphenyl
DDB 1,3-Dimethyl-4,6-di(4'-chlorphenylsulfon)-benzol.

In Tabelle 1 ist weiterhin angegeben die Wärmeformbeständigkeit (Tg) und die Wasseraufnahme nach Lagerung im Normklima (23°C, 50 % rel. Luftfeuchte) und nach Lagerung in $H_2O$ bei 23°C, jeweils nach 180 Tagen.

Tabelle

| Beispiel | Komp. A (mol) | Komp. B (mol) | Komp. C (mol) | Komp. D (mol) | Komp. E (mol) | Tg °C | Wasseraufnahme Normklima | H₂O |
|---|---|---|---|---|---|---|---|---|
| 1V+ | Bis A (0,05) | DHDPS (0,05) | - | DCDPS (0,1) | - | 210 | 0,14 | 1,05 |
| 2V+ | Bis A (0,025) | DHDPS (0,075) | - | DCDPS (0,1) | - | 215 | 0,21 | 1,37 |
| 3V+ | Bis A (0,075) | DHDPS (0,025) | - | DCDPS (0,1) | - | 197 | 0,11 | 0,78 |
| 4V*+ | - | - | - | - | - | 189/224 | 0,18 | 1,15 |
| 5 | Bis A (0,025) | DHDPS (0,05) | T-Bis A (0,025) | DCDPS (0,1) | - | 252 | 0,12 | 0,89 |
| 6 | Bis A (0,025) | DHDPS (0,05) | DHDP (0,025) | DCDPS (0,1) | - | 225 | 0,12 | 0,92 |
| 7 | Bis A (0,025) | DHDPS (0,05) | T-DHDP (0,025) | DCDPS (0,025) | - | 241 | 0,10 | 0,88 |
| 8 | Bis A (0,05) | DHDPS (0,05) | - | DCDPS (0,05) | DDP (0,05) | 255 | 0,16 | 1,09 |
| 9 | Bis A (0,05) | DHDPS (0,05) | - | DCDPS (0,075) | DDP (0,025) | 245 | 0,17 | 1,11 |
| 10 | Bis A (0,05) | DHDPS (0,05) | - | DCDPS (0,05) | DDB (0,05) | 225 | 0,13 | 0,99 |
| 11 | Bis A (0,0375) | DHDPS (0,05) | TMH (0,0125) | DCDPS (0,1) | - | 215 | 0,15 | 1,10 |
| 12 | Bis A (0,025) | DHDPS (0,075) | DHDP (0,05) | DCDPS (0,1) | | 221 | 0,13 | 1,03 |
| 13 | Bis A (0,055) | DHDPS (0,02) | T-DHDP (0,025) | DCDPS (0,1) | | 226 | 0,10 | 0,90 |

* 50/50-Mischung aus Polysulfon und Polyethersulfon

\+ Bei den Beispielen 1 bis 4 handelt es sich um Vergleichsbeispiele

## Ansprüche

1. Hochtemperaturbeständige copolykondensat-Formmassen mit Polyarylensulfon-und Polyarylenethersulfoneinheithen in statistischer Verteilung, erhältlich durch Polykondensation einer Mischung aus

A) 2 bis 98 mol.%, bezogen auf die Summe von A)-C),

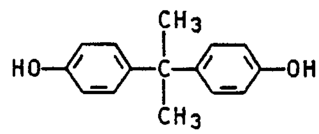

B) 2 bis 98 mol.%, bezogen auf die Summe von A)-C),

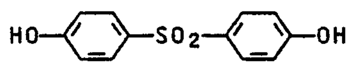

C) 0 bis 96 mol.%, bezogen auf die Summe von A)-C),

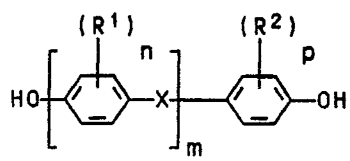

wobei X eine chemische Bindung oder einen Substituenten

-S-, -O-, $-\overset{\overset{O}{\|}}{C}-$,

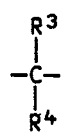

($R^3 \neq R^4$ wenn gleichzeitig n und p = 0),

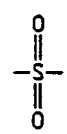

(nur wenn n oder p = 0)

$R^1$ und $R^2$ Alkylgruppen mit 1 bis 6 C-Atomen oder $C_1$-$C_6$-Alkoxygruppen, $R^3$ und $R^4$ Wasserstoff, Alkylgruppen mit 1 bis 6 C-Atomen, Arylgruppen oder halogensubstituierte Alkylgruppen mit 1 bis 4 C-Atomen darstellen und m den Wert 0 oder 1 und n und p den Wert 0, 1, 2, 3 oder 4 haben,
mit

D) 1 bis 100 mol.%, bezogen auf die Summe von D) und E)

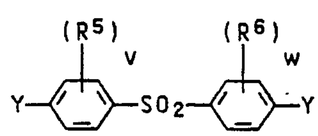

wobei $R^5$ und $R^6$ Wasserstoff sind oder die gleiche Bedeutung wie $R^1$ und $R^2$ haben und v und w jeweils den Wert 0, 1, 2, 3 oder 4 haben, und

E) 0 bis 99 mol.%, bezogen auf die Summe von D) und E)

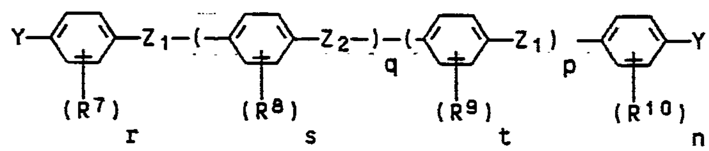

wobei
Y: Cl oder F

Z1: 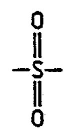

oder - 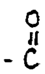 -

$Z_2$: -O-, -S-,

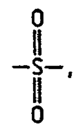,

- 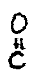 -oder eine chemische Bindung darstellen

$R^7$, $R^8$, $R^9$ und $R^{10}$, Wasserstoff, Cl oder F sind oder die gleiche Bedeutung wie $R^1$ und $R^2$ haben können,
q und p der Wert 0 oder 1 haben und
r, s, t und u eine ganze Zahl von 0 bis 4 sein können,

mit der Maßgabe, daß mindestens eine der Komponenten C oder E enthalten ist und das molare Verhältnis von B zur Summe von A + C nicht größer als 1 ist.

2. Hochtemperaturbeständige Copolykondensat-Formmassen nach Anspruch 1, erhältlich durch Polykondensation einer Mischung aus
25 bis 70 mol.% A
25 bis 70 mol.% B
5 bis 60 mol.% C
, jeweils bezogen auf die Summe von A bis C mit
1 bis 100 mol.% D
0 bis 99 mol.% E,
jeweils bezogen auf die Summe von D und E.

3. Hochtemperaturbeständige Copolykondensat-Formmassen nach Anspruch 1, erhältlich durch Polykondensation einer Mischung aus
20 bis 80 mol.% A
20 bis 80 mol.% B
0 bis 60 mol.% C,
jeweils bezogen auf die Summe von A bis C mit
50 bis 95 mol.% D
5 bis 50 mol.% E,
jeweils bezogen auf die Summe von D + E.

4. Hochtemperaturbeständige Copolykondensat-Formmasse nach Anspruch 1, erhältlich durch Polykondensation einer Mischung von
25 bis 70 mol.% A
25 bis 70 mol.% B
5 bis 60 mol.% C,
jeweils bezogen auf die Summe von A bis C mit
50 bis 95 mol.% D
5 bis 50 mol.% E,
jeweils bezogen auf die Summe von D + E.

5. Verwendung der hochtemperaturbeständigen Copolykondensat-Formmassen gemäß den Ansprüchen 1 bis 4 zur Herstellung von Leiterplatten und elektrischen Steckverbindungen.

6. Formkörper, erhältlich aus Copolykondensat-Formmassen gemäß den Ansprüchen 1 bis 4 als wesentlichen Komponenten.